# EUROPEAN PATENT APPLICATION

(11) **EP 4 764 551 A1**
(43) Date of publication of application: **24.06.2026**
(21) Application number: 25848730.5
(22) Date of filing: 04.07.2025
(51) Int. Cl.: G01R 31/392, G01R 31/396, G01R 31/385, G01R 31/382, G01R 31/36, G01R 31/367, G01R 31/374

(54) **BATTERY DIAGNOSTIC DEVICE AND METHOD THEREFOR**

(30) Priority: 02.08.2024 KR 20240102815
(71) Applicant: LG Energy Solution, Ltd., Seoul 07335 (KR)
(72) Inventor: ROH, Ye Rim, Daejeon 34122 (KR); KIM, Yong Jun, Daejeon 34122 (KR); LEE, Hyeon Ho, Daejeon 34122 (KR); KOH, Dong Wook, Daejeon 34122 (KR); YEOM, In Cheol, Daejeon 34122 (KR)
(74) Representative: Plasseraud IP
(86) International application number: PCT/KR2025/009592
(87) International publication number: WO 2026/029405

(57) **Abstract**

A battery diagnosis device according to an embodiment of this document includes a memory configured to store at least one instruction and at least one processor configured to execute the at least one instruction, the at least one processor is configured to identify a set of data measured from a battery cell while the battery cell is in use and times at which the set of data is acquired, identify a plurality of data regions including at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof, and diagnose a state of the battery cell based on battery data regions including the set of data among the plurality of data regions, and holding times corresponding to each of the battery data regions among the times, and the data includes at least one of a value of the first state variable, a value of the second state variable, a value of the third state variable, or any combination thereof.

## Description

### TECHNICAL FIELD

### Cross-reference to Related Applications

This application claims priority from Korean Patent Application No. 10-2024-0102815, filed on August 2, 2024, the disclosure of which is incorporated by reference herein.

### Technical Field

Embodiments disclosed in this document relate to a battery diagnosis device and battery diagnosis method.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

With the proliferation of electronic devices due to the Fourth Industrial Revolution, battery usage is increasing dramatically. Batteries are in the spotlight as an essential energy source in various applications, such as electric vehicles, portable electronic devices, and renewable energy storage systems, and accordingly, the importance of technology for diagnosing a battery state to improve battery performance and reliability is increasing.

In particular, a technology for improving the accuracy of life diagnosis of a battery is attracting attention. When the accuracy of the life diagnosis of the battery is improved, the maintenance costs of the battery may be reduced and battery use may be optimized.

### DISCLOSURE OF THE INVENTION

### TECHNICAL PROBLEM

Embodiments disclosed in this document provide a battery diagnosis device and battery diagnosis method that identify an operating pattern of a battery unit by identifying battery data regions and holding times based on a set of data acquired from the battery unit.

Embodiments disclosed in this document provide a battery diagnosis device and battery diagnosis method that improve the accuracy of diagnosis for a battery unit by inputting an operating pattern of the battery unit identified based on a set of data acquired from the battery unit into a learning model.

Embodiments disclosed in this document provide a battery diagnosis device and battery diagnosis method that perform a diagnosis on a battery unit in consideration of degradation while the battery unit is not in operation by identifying the time for which the battery unit is not in operation.

Embodiments disclosed in this document provide a battery diagnosis device and battery diagnosis method that contribute to improving the stability of a battery including a battery unit by improving the accuracy of diagnosis for the battery unit.

The technical problems of the embodiments disclosed in this document are not limited to the technical problems mentioned above, and other technical problems that are not mentioned may be clearly understood by those skilled in the art from the descriptions below.

### TECHNICAL SOLUTION

A battery diagnosis device according to an embodiment of this document includes a memory configured to store at least one instruction and at least one processor configured to execute the at least one instruction.

According to an embodiment, the at least one processor may be configured to identify a set of data measured from a battery cell while the battery cell is in use and times at which the set of data is acquired, identify a plurality of data regions including at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof, and diagnose a state of the battery cell based on battery data regions including the set of data among the plurality of data regions, and holding times corresponding to each of the battery data regions among the times, and the data includes at least one of a value of the first state variable, a value of the second state variable, a value of the third state variable, or any combination thereof.

According to an embodiment, the at least one processor may be configured to identify a specific data region among the battery data regions based on at least one of a first specific range including a specific value of the first state variable among the plurality of first ranges, a second specific range including a specific value of the second state variable among the plurality of second ranges, a third specific range including a specific value of the third state variable among the plurality of third ranges, or any combination thereof, identify a specific time corresponding to the specific data region based on a time for which the first state variable is included in the first specific range, the second state variable is included in the second specific range, the third state variable is included in the third specific range among the holding times, and correspond the holding times to each of the battery data regions based on the specific data region and the specific time.

According to an embodiment, the at least one processor may be configured to identify the set of data of a time for which the battery was not in operation, based on at least one of the first state variable acquired within a second time after the battery began to operate, the second state variable acquired within the second time after the battery began to operate, and the third state variable acquired within the second time after the battery began to operate, or any combination thereof, when the battery including the battery cell has not been operated for a first time or more.

According to an embodiment, the at least one processor may be configured to adjust the holding times so that a sum of the holding times reaches a specified value and a ratio between the holding times is maintained, generate a histogram based on at least one of the plurality of first ranges, the plurality of second ranges, the plurality of third ranges, or any combination thereof, and the adjusted holding times, and diagnose a state of the battery cell based on the histogram.

According to an embodiment, the at least one processor may be configured to identify at least one of the first state variable, the second state variable, the third state variable, or any combination thereof based on at least one of a temperature, voltage, current, or a combination thereof of the battery cell.

According to an embodiment, the at least one processor may be configured to acquire a predicted remaining useful life (RUL) of a battery cell from a learning model by inputting input data according to the battery data regions and the holding times into the learning model.

According to an embodiment, the at least one processor may be configured to acquire a set of data for the specified period of time by correcting the set of data based on temperature changes for a specified period of time longer than a period of time during which the set of data was identified.

According to an embodiment, the at least one processor may be configured to acquire a predicted remaining useful life (RUL) of a battery cell from a learning model by inputting input data according to the histogram into the learning model.

A battery diagnosis method according to an embodiment of this document includes an operation of identifying a set of data measured from a battery cell while the battery cell is in use and times at which the set of data is acquired, an operation of identifying a plurality of data regions including at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof, and an operation of diagnosing a state of the battery cell based on battery data regions include the set of data among the plurality of data regions, and holding times corresponding to each of the battery data regions among the times, and the data includes at least one of a value of the first state variable, a value of the second state variable, a value of the third state variable, or any combination thereof.

According to an embodiment, the operation of diagnosing the state of the battery cell based on battery data regions including the set of data among the plurality of data regions, and the holding times corresponding to each of the battery data regions among the times may include an operation of identifying a specific data region among the battery data regions based on at least one of a first specific range including a specific value of the first state variable among the plurality of first ranges, a second specific range including a specific value of the second state variable among the plurality of second ranges, a third specific range including a specific value of the third state variable among the plurality of third ranges, or any combination thereof, an operation of identifying a specific time corresponding to the specific data region based on a time for which the first state variable is included in the first specific range, the second state variable is included in the second specific range, the third state variable is included in the third specific range among the holding times, and an operation of corresponding the holding times to each of the battery data regions based on the specific data region and the specific time.

According to an embodiment, the operation of diagnosing the state of the battery cell based on battery data regions including the set of data among the plurality of data regions, and the holding times corresponding to each of the battery data regions among the times may include an operation of identifying the set of data of a time for which the battery was not in operation, based on at least one of the first state variable acquired within a second time after the battery began to operate, the second state variable acquired within the second time after the battery began to operate, and the third state variable acquired within the second time after the battery began to operate, or any combination thereof, when the battery including the battery cell was not operated for a first time or more.

According to an embodiment, the operation of diagnosing the state of the battery cell based on battery data regions including the set of data among the plurality of data regions, and the holding times corresponding to each of the battery data regions among the times may include an operation of adjusting the holding times so that a sum of the holding times reaches a specified value and a ratio between the holding times is maintained, an operation of generating a histogram based on at least one of the plurality of first ranges, the plurality of second ranges, the plurality of third ranges, or any combination thereof, and the adjusted holding times and an operation of diagnosing a state of the battery cell based on the histogram.

According to an embodiment, the operation of identifying a plurality of data regions including at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof may include an operation of identifying at least one of the first state variable, the second state variable, the third state variable, or any combination thereof based on at least one of a temperature, voltage, current, or a combination thereof of the battery cell.

According to an embodiment, the operation of diagnosing the state of the battery cell based on battery data regions including the set of data among the plurality of data regions, and the holding times corresponding to each of the battery data regions among the times may include an operation of acquiring a predicted remaining useful life (RUL) of a battery cell from a learning model by inputting input data according to the battery data regions and the holding times into the learning model.

According to an embodiment, the operation of diagnosing the state of the battery cell based on battery data regions including the set of data among the plurality of data regions, and the holding times corresponding to each of the battery data regions among the times may include an operation of acquiring a set of data for the specified period of time by correcting the set of data based on temperature changes for a specified period of time longer than a period of time during which the set of data was identified.

According to an embodiment, the operation of diagnosing the state of the battery cell based on the histogram may include an operation of acquiring a predicted remaining useful life (RUL) of a battery cell from a learning model by inputting input data according to the histogram into the learning model.

### ADVANTAGEOUS EFFECTS

The present technology can identify an operating pattern of a battery unit by identifying battery data regions and holding times based on a set of data acquired from the battery unit.

In addition, the present technology can improve the accuracy of diagnosis for a battery unit by inputting an operating pattern of the battery unit identified based on a set of data acquired from the battery unit into a learning model.

In addition, the present technology can perform a diagnosis on a battery unit in consideration of degradation while the battery unit is not in operation by identifying the time for which the battery unit is not in operation.

In addition, the present technology can contribute to improving the stability of a battery including a battery unit by improving the accuracy of diagnosis for the battery unit.

In addition, various effects that are directly or indirectly identified through this document can be provided.

### BRIEF DESCRIPTION OF THE DRAWINGS

FIG. 1 is a block diagram illustrating a battery pack in a battery diagnosis device and battery diagnosis method according to an embodiment of this document.
FIG. 2 is a block diagram illustrating the configuration of a battery diagnosis device, in a battery diagnosis device and battery diagnosis method according to an embodiment of this document.
FIG. 3 illustrates an example of a data region, in a battery diagnosis device and a battery diagnosis method according to an embodiment of this document.
FIG. 4 illustrates an example of a data set for a time for which the battery was not in operation, in a battery diagnosis device and a battery diagnosis method according to an embodiment of this document.
FIG. 5 illustrates an example of temperature changes used to correct a set of data, in a battery diagnosis device and a battery diagnosis method according to an embodiment of this document.
FIG. 6 illustrates an example of an operational flow of a battery diagnosis device that diagnoses a state of a battery cell based on battery data regions and holding times, in a battery diagnosis device and a battery diagnosis method according to an embodiment of this document.
FIG. 7 is a block diagram illustrating a hardware configuration of a computing system that performs a battery diagnosis method, in a battery diagnosis device and battery diagnosis method according to an embodiment of this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

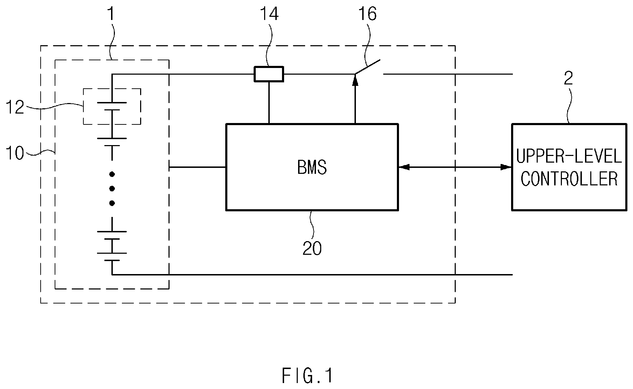

Hereinafter, embodiments of this document will be described in detail with reference to FIGS. 1 to 7.

FIG. 1 is a block diagram showing a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV) or an energy storage system (ESS).

According to an embodiment, the battery unit 12 may include at least one battery unit 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for voltage, current, resistance, a state of charge (SOC), a state of health (SOH), or temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharge and overdischarge, etc. by monitoring the voltage, current, temperature, etc. of the battery pack 1. For example, the battery management system 20 is an interface that receives values obtained by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

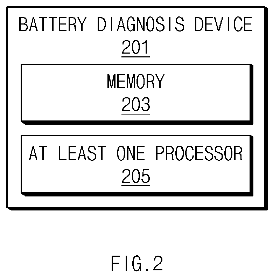

According to an embodiment, the battery management system 20 may include a battery diagnosis device 201 of FIG. 2. According to another embodiment, the battery management system 20 may be a different system from the battery diagnosis device 201 of FIG. 2. That is, the battery diagnosis device 201 of FIG. 2 may be included in the battery pack 1 or may be configured as another device external to the battery pack 1. Hereinafter, for convenience of description, the description will be made on the assumption that the battery diagnosis device 201 is composed of another device external to the battery pack 1. In addition, the operation of the battery diagnosis device 201 described below may be performed by a BMS in the vehicle, and may also be performed by various devices such as a server, a cloud, a charger, or a discharger.

FIG. 2 is a block diagram illustrating the configuration of a battery diagnosis device, in a battery diagnosis device and a battery diagnosis method according to an embodiment of this document.

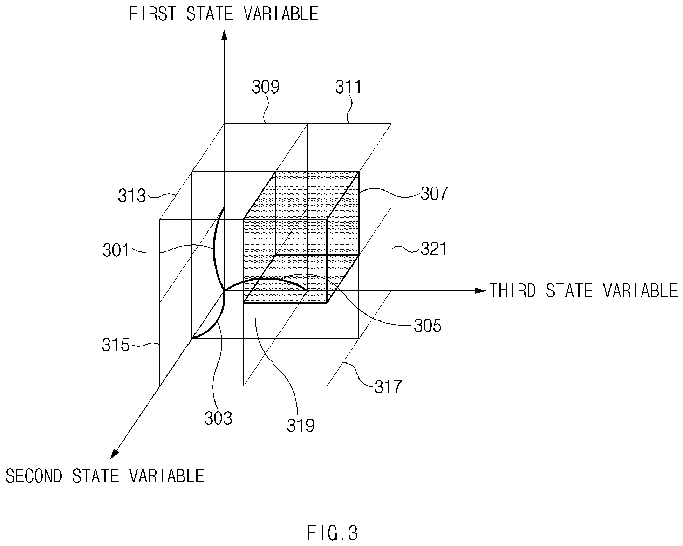

FIG. 3 illustrates an example of a data region, in a battery diagnosis device and a battery diagnosis method according to an embodiment of this document.

Referring to FIGS. 2 and 3, a battery diagnosis device 201 may include a memory 203 and at least one processor 205. The memory 203 may store at least one instruction. The at least one processor 205 may execute at least one instruction. A first range may be one of a plurality of first ranges that divide a first state variable into a first size 301. A second range may be one of a plurality of second ranges that divide a second state variable into a second size 303. A third range may be one of a plurality of third ranges that divide a third state variable into a third size 305. A battery data region 307 which is a first data region, a second data region 309, a third data region 311, a fourth data region 313, a fifth data region 315, a sixth data region 317, a seventh data region 319, and an eighth data region 321 may represent a plurality of data regions that include at least one of a plurality of first ranges, a plurality of second ranges, a plurality of third ranges, or any combination thereof. The battery data region 307 may represent a region in which a set of data is included among a plurality of data regions.

According to an embodiment, the at least one processor 205 of the battery diagnosis device 201 may acquire data measured from a battery cell while the battery cell is in use. The data may include values of state variables (e.g., voltage, current, temperature) of the battery cell over time. The data may be acquired from on-board diagnostics (OBD), but the embodiments of this document may not be limited thereto.

According to an embodiment, the at least one processor 205 of the battery diagnosis device 201 may acquire the remaining useful life (RUL) of the battery cell from a learning model by inputting the data into the learning model. In this case, in order to improve the accuracy of the predicted remaining useful life, the at least one processor 205 of the battery diagnosis device 201 may process data and input the data into learning data.

According to an embodiment, the at least one processor 205 of the battery diagnosis device 201 may synthesize data and identify the data as a set of data. In other words, the at least one processor 205 of the battery diagnosis device 201 may identify at least one of data regarding a value of the first state variable (e.g., temperature), data regarding a value of the second state variable (e.g., voltage), data regarding a value of the third state variable (e.g., current), or any combination thereof as the set of data.

According to an embodiment, the at least one processor 205 of the battery diagnosis device 201 may identify a plurality of data regions (e.g., the battery data region 307, which is a first data region, the second data region 309, the third data region 311, the fourth data region 313, the fifth data region 315, the sixth data region 317, the seventh data region 319, and the eighth data region 321) that include at least one of a plurality of first ranges that divide the first state variable of the battery cell into the first size 301, a plurality of second ranges that divide the second state variable of the battery cell into the second size 303, a plurality of third ranges that divide the third state variable of the battery cell into the third size 305, or any combination thereof.

According to an embodiment, the at least one processor 205 of the battery diagnosis device 201 may identify battery data regions (e.g., the battery data region 307) that include the set of data among the plurality of data regions.

According to an embodiment, the at least one processor 205 of the battery diagnosis device 201 may identify a holding time corresponding to a battery data region based on a time for which the first state variable included in the set of data is included in the first range corresponding to the battery data region, the second state variable included in the set of data is included in the second range corresponding to the battery data region, and the third state variable included in the set of data is included in the third range corresponding to the battery data region.

According to an embodiment, the at least one processor 205 of the battery diagnosis device 201 may identify data as being included in a specific data region when a specific value of the first state variable of data acquired from the battery is included in a specific range of the first state variable represented by a specific data region, a specific value of the second state variable of data acquired from the battery is included in a specific range of the second state variable represented by a specific data region, and a specific value of the third state variable of data acquired from the battery is included in a specific range of the third state variable represented by a specific data region. The at least one processor 205 of the battery diagnosis device 201 may accumulate and calculate the time for which the data acquired from the battery is included in the specific data region. The at least one processor 205 of the battery diagnosis device 201 may acquire a holding time, which is the total time for which the data is included in a specific data region, by adding up the time from the moment when data acquired from the battery falls within a specific data region to the moment when the data falls outside the specific data region.

According to an embodiment, the at least one processor 205 of the battery diagnosis device 201 may diagnose the state of the battery cell (e.g., the remaining useful life of the battery cell) by inputting the battery data regions (e.g., the battery data region 307) and the holding times corresponding to each of the battery areas into the learning model.

According to an embodiment, the at least one processor 205 of the battery diagnosis device 201 may generate a histogram based on the battery data regions and the holding times corresponding to each of the battery areas, and input the generated histogram into the learning model.

According to an embodiment, the at least one processor 205 of the battery diagnosis device 201 may adjust the holding times so that the sum of the holding times reaches a specified value (e.g., approximately 1) and a ratio between the holding times is maintained.

According to an embodiment, the at least one processor 205 of the battery diagnosis device 201 may adjust the holding time (e.g., approximately 0.375 based on a ratio of the holding time (e.g., approximately 3 hours) corresponding to a specific battery data region to 24 hours (e.g., approximately 0.375) to normalize each of the holding times.

According to an embodiment, the at least one processor 205 of the battery diagnosis device 201 may generate a histogram by representing the battery data regions as regions included in a three-dimensional grid and representing the adjusted holding time of each of battery data regions with a dark degree of color.

According to an embodiment, the at least one processor 205 of the battery diagnosis device 201 may diagnose the state of the battery cell (e.g., the remaining useful life (RUL) of the battery cell) based on inputting a histogram into the learning model.

This is because the degree of degradation of the battery cell is determined according to the operating pattern of the battery cell that powers an electronic device.

The learning model may identify the operating pattern of the battery cell through the histogram. The operating pattern of the battery may be determined according to an operation pattern of the electronic device including the battery cell. For example, a discharge current of a battery cell when an operator of an electronic device operates the electronic device so that the electronic device) consumes high power may be higher than the discharge current of the battery cell when the operator operates the electronic device so that the electronic device consumes low power. If a specific operator primarily operates the electronic device, the at least one processor 205 of the battery diagnosis device 201 may predict the degree of degradation of the battery cell according to the operation pattern of the battery cell according to the operator.

According to an embodiment, the at least one processor 205 of the battery diagnosis device 201 may identify the operation pattern of the electronic device including the battery cell through a histogram.

However, the embodiments of this document may not be limited thereto. For example, the at least one processor 205 of the battery diagnosis device 201 may input data according to the battery data regions and the holding times corresponding to each of the battery regions into the learning model without generating the histogram.

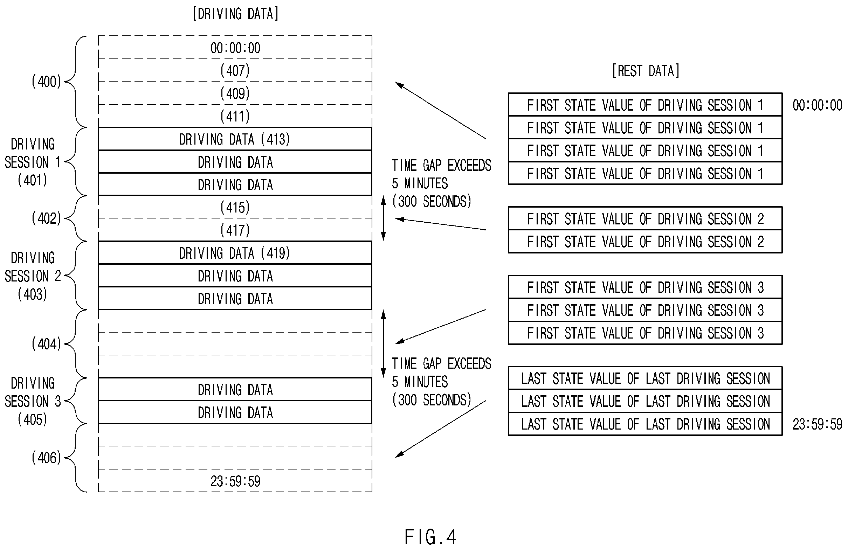

FIG. 4 illustrates an example of a set of data for a time for which a battery was not in operation, in a battery diagnosis device and a battery diagnosis method according to an embodiment of this document.

Referring to FIG. 4, a first session 400 may represent a first section on a specific date during which the battery including the battery cell was not in operation. A second session 401 may represent a first section on a specific date during which the battery including the battery cell was in operation. A third session 402 may represent a second section on the specific date during which the battery including the battery cell was not in operation. A fourth session 403 may represent a second section on the specific date during which the battery including the battery cell was in operation. A fifth session 404 may represent a third section on the specific date during which the battery including the battery cell was not in operation. A sixth session 405 may represent a third section on the specific date during which the battery including the battery cell was in operation. A seventh session 406 may represent the last section on the specific day during which the battery including the battery cell was not in operation.

According to an embodiment, the at least one processor 205 of the battery diagnosis device 201 may identify a set of data of a time for which the battery was not in operation, based on at least one of a first state variable acquired within a second time (e.g., approximately 0.5 seconds) after the battery begins to operate, a second state variable acquired within the second time after the battery begins to operate, a third state variable acquired within the second time after the battery begins to operate, or any combination thereof, when a battery including a battery cell has not been operated for a first time (e.g., about 300 seconds) or more.

For example, the at least one processor 205 of the battery diagnosis device 201 may identify a set of data in the first section 407, the second section 409, and the third section 411 based on at least one of the first state variable acquired within the second time after the battery begins to operate, the second state variable acquired within the second time after the battery begins to operate, the third state variable acquired within the second time after the battery begins to operate, or any combination thereof, in the fourth section 413 included in the second session 403, based on the fact that the battery has not been operated for a first time or more in the first section 407, the second section 409, and the third section 411 included in the first session 400.

For example, the at least one processor 205 of the battery diagnosis device 201 may identify a set of data in the fifth section 415 and sixth section 417 based on at least one of the first state variable acquired within the second time after the battery begins to operate, the second state variable acquired within the second time after the battery begins to operate, the third state variable acquired within the second time after the battery begins to operate, or any combination thereof in the seventh section 419 included in the fourth session 403, based on the fact that the battery has not been operated for a first time or more in the fifth section 415 and the sixth section 417 included in the third session 402.

For example, the at least one processor 205 of the battery diagnosis device 201 may identify a set of data in the sections included in the fifth session 404 based on at least one of the first state variable acquired within the second time after the battery begins to operate, the second state variable acquired within the second time after the battery begins to operate, the third state variable acquired within the second time after the battery begins to operate, or any combination thereof in the section included in the sixth session 405, based on the fact that the battery including the battery cell has not been operated for a first time or more in the section included in the fifth session 404.

The at least one processor 205 of the battery diagnosis device 201 may identify a set of data for the time the battery was not in operation based on at least one of the first state variable acquired within a second time after the battery begins to operate, the second state variable acquired within the second time after the battery begins to operate, the third state variable acquired within the second time after the battery begins to operate, or any combination thereof when the battery including the battery cell has not been operated for a first time or more.

For example, the at least one processor 205 of the battery diagnosis device 201 may identify a set of data in the sections included in the seven session 406 based on at least one of a first state variable acquired within a second time immediately before the battery ends its operation in the sixth session 405, a second state variable acquired within the second time immediately before the battery ends its operation in the sixth session 405, a third state variable acquired within the second time immediately before the battery ends its operation in the sixth session 405, or any combination thereof, based on the fact that the battery has not been operated for a first time or more in the seventh session 406.

According to an embodiment, since a battery may degrade even while the battery cell is not in operation, the at least one processor 205 of the battery diagnosis device 201 may reference a set of data before and after the battery begins to operate to calculate a holding time corresponding to the battery data region while the battery cell is not in operation.

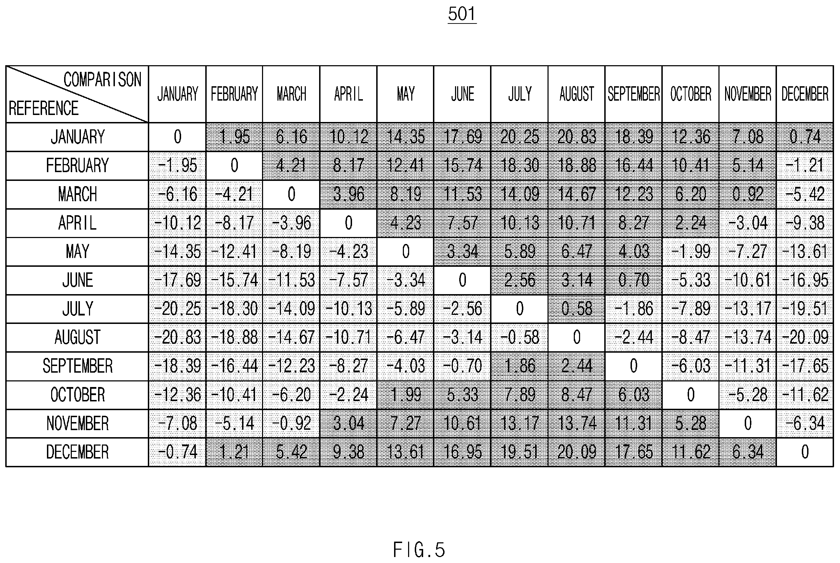

FIG. 5 illustrates an example of temperature changes used to correct a set of data, in a battery diagnosis device and a battery diagnosis method according to an embodiment of this document.

Referring to FIG. 5, a table 501 may represent monthly temperature changes used to correct the set of data.

According to an embodiment, the at least one processor 205 of the battery diagnosis device 201 may acquire a set of data for a specified period of time by correcting the set of data (e.g., the set of data identified for about 30 days) based on temperature changes over a specified period of time (e.g., about one year) longer than a period of time during which the set of data was identified (e.g., about 30 days).

For example, the at least one processor 205 of the battery diagnosis device 201 may acquire a set of data in a specific section (e.g., July). For example, when temperature is included among the state variables included in the set of data, the at least one processor 205 of the battery diagnosis device 201 may acquire a set of data from other sections (e.g., January, February, March, April, May, June, August, September, October, November, December) within a specified period of time by shifting the temperature included in the set of data using the table 501.

For example, when temperature is included among the state variables included in the set of data, the at least one processor 205 of the battery diagnosis device 201 may acquire a set of data in another section (e.g., June) by shifting the temperature included in the data set (e.g., shifting by approximately -2.56 °C) using the table 501.

According to an embodiment, the at least one processor 205 of the battery diagnosis device 201 may acquire the state of a battery cell (e.g., the predicted remaining useful life of the battery cell) from the learning model by inputting input data according to the set of data for a specified period of time (e.g., approximately one year) into the learning model.

According to an embodiment, the accuracy of a diagnosis performed by inputting a set of data for a specified period of time (e.g., approximately one year) into the learning model may be higher than the accuracy of a diagnosis performed by inputting a set of data into the learning model. This is because the set of data for the specified period of time includes information about temperature changes due to seasonal changes.

According to an embodiment, the at least one processor 205 of the battery diagnosis device 201 may identify a set of data for a determined period of time.

According to an embodiment, when the set of data is identified only for a period of time shorter than a specified period of time, the accuracy of the diagnosis may decrease. When the set of data is identified for a period of time that exceeds the specified period of time, the habit of an operator operating the electronic device may change. The period of time for identifying the set of data may be determined to be a period of time that allows the operating patterns of the battery cells to be representative without changing significantly. The period of time for identifying the set of data may be determined by the Kullback-Leibler (KL) divergence method, which measures the difference between two probability distributions, or the Jensen-Shannon Divergence (JSD) method, which measures the similarity between two probability distributions.

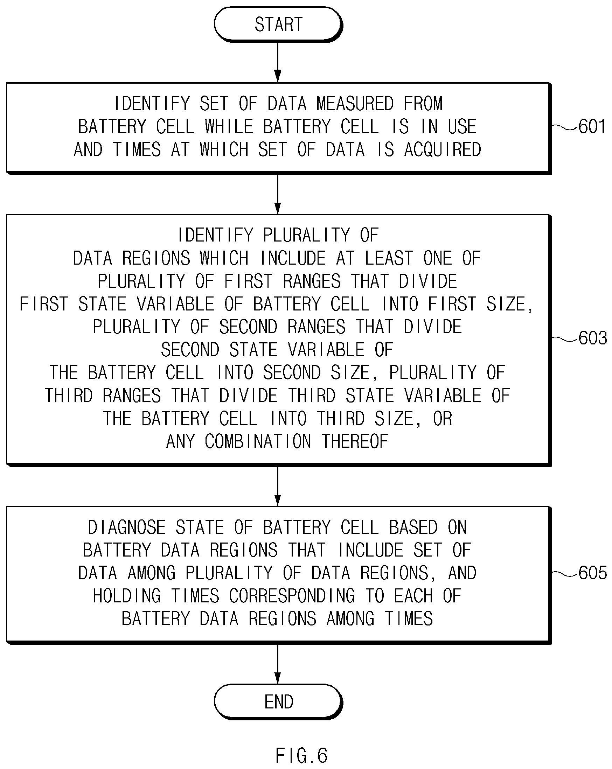

FIG. 6 illustrates an example of the operational flow of a battery diagnosis device which diagnoses the state of a battery cell based on battery data regions and the holding times, in a battery diagnosis device and a battery diagnosis method according to an embodiment of this document.

Referring to FIG. 6, in a first operation 601, the at least one processor 205 of the battery diagnosis device 201 according to an embodiment may identify a set of data measured from a battery cell while the battery cell is in use, and the times at which the set of data is acquired.

In a second operation 603, the at least one processor 205 of the battery diagnosis device 201 according to an embodiment may identify a plurality of data regions which include at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof.

In a third operation 605, the at least one processor 205 of the battery diagnosis device 201 according to an embodiment may diagnose the state of the battery cell based on battery data regions that include the set of data among the plurality of data regions, and the holding times corresponding to each of the battery data regions among the times.

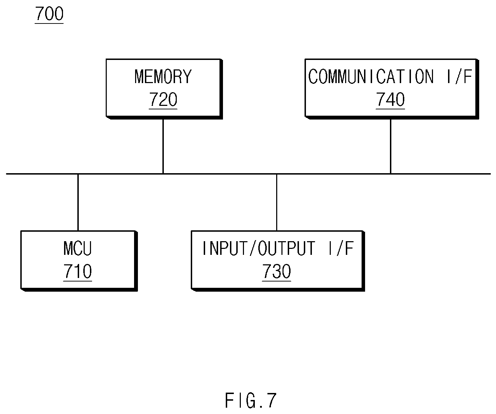

FIG. 7 is a block diagram illustrating a hardware configuration of a computing system that performs a battery diagnosis method, in a battery diagnosis device and battery diagnosis method according to an embodiment of this document.

Referring to FIG. 7, a computing system 700 according to an embodiment disclosed in this document may include an MCU 710, a memory 720, an input/output interface 730, and a communication interface 740.

The MCU 710 may be one or more processors that executes various programs (e.g., battery cell data collection program, graph generation program, data analysis program, data decomposition algorithm, normalization program, and battery cell diagnosis program, etc.) stored in the memory 1220, processes various information including battery cell characteristic data, latent variables, etc. through these programs, and performs the functions of the battery diagnosis device 101 shown in FIGS. 2 to 5 described above.

The memory 720 may store various programs such as the battery cell data collection program, the graph generation program, the data analysis program, the data decomposition algorithm, the normalization program, and the battery cell diagnosis program.

A plurality of such memories 720 may be provided as needed. The memory 720 may be a volatile memory or a nonvolatile memory. The memory 720 used as the volatile memory may be RAM, DRAM, SRAM, etc. The memory 720 used as the nonvolatile memory may be ROM, PROM, EAROM, EPROM, EEPROM, flash memory, etc. The examples of the memories 720 listed above are only examples, but are not limited to these examples.

The I/F 730 may provide an interface that allows data to be transmitted and received by connecting an input device (not shown) such as a keyboard, mouse, or touch panel and an output device (not shown) such as a display with the MCU 710.

The communication I/F 740 is a configuration that can transmit and receive various data with the server, and may be various devices that can support wired or wireless communication. For example, the battery diagnosis device 201 may transmit and receive various information including shape models of battery cells, etc. to and from a separately provided external server through the communication I/F 740.

In this way, the computer program according to an embodiment disclosed in this document may be implemented as a module that performs, for example, each function shown in FIG. 2, by being recorded in the memory 720 and processed by the MCU 710.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

1. A battery diagnosis device, comprising:
a memory configured to store at least one instruction; and
at least one processor configured to execute the at least one instruction,
wherein the at least one processor is configured to:
identify a set of data measured from a battery cell while the battery cell is in use and times at which the set of data is acquired;
identify a plurality of data regions including at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof; and
diagnose a state of the battery cell based on battery data regions including the set of data among the plurality of data regions, and holding times corresponding to each of the battery data regions among the times, and
the data includes at least one of a value of the first state variable, a value of the second state variable, a value of the third state variable, or any combination thereof.

2. The battery diagnosis device of claim 1, wherein the at least one processor is configured to:
identify a specific data region among the battery data regions based on at least one of a first specific range including a specific value of the first state variable among the plurality of first ranges, a second specific range including a specific value of the second state variable among the plurality of second ranges, a third specific range including a specific value of the third state variable among the plurality of third ranges, or any combination thereof;
identify a specific time corresponding to the specific data region based on a time for which the first state variable is included in the first specific range, the second state variable is included in the second specific range, the third state variable is included in the third specific range among the holding times; and
correspond the holding times to each of the battery data regions based on the specific data region and the specific time.

3. The battery diagnosis device of claim 1, wherein the at least one processor is configured to identify the set of data of a time for which the battery was not in operation, based on at least one of the first state variable acquired within a second time after the battery began to operate, the second state variable acquired within the second time after the battery began to operate, and the third state variable acquired within the second time after the battery began to operate, or any combination thereof, when the battery including the battery cell has not been operated for a first time or more.

4. The battery diagnosis device of claim 1, wherein the at least one processor is configured to:
adjust the holding times so that a sum of the holding times reaches a specified value and a ratio between the holding times is maintained;
generate a histogram based on at least one of the plurality of first ranges, the plurality of second ranges, the plurality of third ranges, or any combination thereof, and the adjusted holding times; and
diagnose a state of the battery cell based on the histogram.

5. The battery diagnosis device of claim 1, wherein the at least one processor is configured to identify at least one of the first state variable, the second state variable, the third state variable, or any combination thereof based on at least one of a temperature, voltage, current, or a combination thereof of the battery cell.

6. The battery diagnosis device of claim 1, wherein the at least one processor is configured to acquire a predicted remaining useful life (RUL) of a battery cell from a learning model by inputting input data according to the battery data regions and the holding times into the learning model.

7. The battery diagnosis device of claim 1, wherein the at least one processor is configured to acquire a set of data for the specified period of time by correcting the set of data based on temperature changes for a specified period of time longer than a period of time during which the set of data was identified.

8. The battery diagnosis device of claim 4, wherein the at least one processor is configured to acquire a predicted remaining useful life (RUL) of a battery cell from a learning model by inputting input data according to the histogram into the learning model.

9. A battery diagnosis method comprising:
an operation of identifying a set of data measured from a battery cell while the battery cell is in use and times at which the set of data is acquired;
an operation of identifying a plurality of data regions including at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof; and
an operation of diagnosing a state of the battery cell based on battery data regions include the set of data among the plurality of data regions, and holding times corresponding to each of the battery data regions among the times, and
wherein the data includes at least one of a value of the first state variable, a value of the second state variable, a value of the third state variable, or any combination thereof.

10. The battery diagnosis method of claim 9, wherein the operation of diagnosing the state of the battery cell based on battery data regions including the set of data among the plurality of data regions, and the holding times corresponding to each of the battery data regions among the times includes:
an operation of identifying a specific data region among the battery data regions based on at least one of a first specific range including a specific value of the first state variable among the plurality of first ranges, a second specific range including a specific value of the second state variable among the plurality of second ranges, a third specific range including a specific value of the third state variable among the plurality of third ranges, or any combination thereof;
an operation of identifying a specific time corresponding to the specific data region based on a time for which the first state variable is included in the first specific range, the second state variable is included in the second specific range, the third state variable is included in the third specific range among the holding times; and
an operation of corresponding the holding times to each of the battery data regions based on the specific data region and the specific time.

11. The battery diagnosis method of claim 9, wherein the operation of diagnosing the state of the battery cell based on battery data regions including the set of data among the plurality of data regions, and the holding times corresponding to each of the battery data regions among the times includes an operation of identifying the set of data of a time for which the battery was not in operation, based on at least one of the first state variable acquired within a second time after the battery began to operate, the second state variable acquired within the second time after the battery began to operate, and the third state variable acquired within the second time after the battery began to operate, or any combination thereof, when the battery including the battery cell was not operated for a first time or more.

12. The battery diagnosis method of claim 9, wherein the operation of diagnosing the state of the battery cell based on battery data regions including the set of data among the plurality of data regions, and the holding times corresponding to each of the battery data regions among the times includes:
an operation of adjusting the holding times so that a sum of the holding times reaches a specified value and a ratio between the holding times is maintained;
an operation of generating a histogram based on at least one of the plurality of first ranges, the plurality of second ranges, the plurality of third ranges, or any combination thereof, and the adjusted holding times; and
an operation of diagnosing a state of the battery cell based on the histogram.

13. The battery diagnosis method of claim 9, wherein the operation of identifying a plurality of data regions including at least one of a plurality of first ranges that divide a first state variable of the battery cell into a first size, a plurality of second ranges that divide a second state variable of the battery cell into a second size, a plurality of third ranges that divide a third state variable of the battery cell into a third size, or any combination thereof includes an operation of identifying at least one of the first state variable, the second state variable, the third state variable, or any combination thereof based on at least one of a temperature, voltage, current, or a combination thereof of the battery cell.

14. The battery diagnosis method of claim 9, wherein the operation of diagnosing the state of the battery cell based on battery data regions including the set of data among the plurality of data regions, and the holding times corresponding to each of the battery data regions among the times includes an operation of acquiring a predicted remaining useful life (RUL) of a battery cell from a learning model by inputting input data according to the battery data regions and the holding times into the learning model.

15. The battery diagnosis method of claim 9, wherein the operation of diagnosing the state of the battery cell based on battery data regions including the set of data among the plurality of data regions, and the holding times corresponding to each of the battery data regions among the times includes an operation of acquiring a set of data for the specified period of time by correcting the set of data based on temperature changes for a specified period of time longer than a period of time during which the set of data was identified.

16. The battery diagnosis method of claim 12, wherein the operation of diagnosing the state of the battery cell based on the histogram includes an operation of acquiring a predicted remaining useful life (RUL) of a battery cell from a learning model by inputting input data according to the histogram into the learning model.
